# EUROPEAN PATENT SPECIFICATION

(11) **EP 4 089 664 B1**
(45) Date of publication and mention of the grant of the patent: **27.08.2025**
(21) Application number: 20911743.1
(22) Date of filing: 06.01.2020
(51) Int. Cl.: H05K 7/20, H10K 50/84

(54) **DISPLAY DEVICE**
ANZEIGEVORRICHTUNG
DISPOSITIF D'AFFICHAGE

(43) Date of publication of application: 16.11.2022
(73) Proprietor: LG Electronics Inc., Seoul 07336 (KR)
(72) Inventor: JUNG, Jaeyong, Seoul 06772 (KR); HYUN, Jihwan, Seoul 06772 (KR)
(74) Representative: Schornack, Oliver
(86) International application number: PCT/KR2020/000201
(87) International publication number: WO 2021/141148

(56) References cited:
- KR-A- 20110 070 155
- KR-A- 20190 060 074
- US-A1- 2011 063 265
- US-A1- 2015 323 262
- US-A1- 2019 116 691
- US-B2- 8 172 097
- US-B2- 9 265 182

## Description

### Technical Field

The present disclosure relates to a display device.

### Background Art

With the development of the information society, there have been growing demands for various types of display devices, and in order to meet these demands, research has been conducted thereon and various display devices have been used recently, including a liquid crystal display (LCD), a plasma display panel (PDP), an electroluminescent display (ELD), a vacuum fluorescent display (VFD), an Organic Light Emitting Diode (OLED), and the like.

Among them, a display device using an organic light emitting diode (OLED) has excellent luminance and viewing angle characteristics in comparison with a liquid crystal display device, and requires no backlight unit, such that the OLED display device can be implemented as an ultrathin display device.

In addition, a lot of research has been done to effectively remove heat generated when a large-screen and ultra-thin display device displays high-definition images.

For example, a vapor chamber, which serves as a heat dissipation structure applied to the display device, is an element embedded in the display device and cools a heating element that generates high-temperature heat. Accordingly, it is possible to prevent thermal damage to electronic elements located adjacent to the heating element due to spatial constraints.
US 2015/0323262 A1 is directed to an electronic device having a heat dissipating apparatus. In one aspect, the electronic device is a TV and the heat dissipating apparatus includes a vapor chamber. The electronic device further includes a body with a display unit, an internal circuit board having at least one heat generating element as well as an interference element, and a rear case. A predetermined portion on a surface of the vapor chamber is engaged with the heat generating element so that the edges are located at a position near the periphery of the inside of the body, in order to widely diffuse the heat generated by the heat generating element, so that the high temperature heat generated by the heat generating element is diffused to an outermost end of the vapor chamber. The vapor chamber includes a first metal plate, a second metal plate, a refrigerant provided therebetween, and embedded members for absorbing and transferring the refrigerant according to the phase change of the refrigerant. The vapor chamber has a cut surface (e.g., indentations or cutouts) formed by cutting a part of the vapor chamber according to a position of the interference element.
US 2019/0116691 A1 is directed to cooling of semiconductor devices. A titanium thermal ground plane comprises a titanium substrate with a wicking structure, a backplane, and a vapor chamber. The thermal ground plane is charged with a working fluid, such as water in a thermodynamically saturated state, where the liquid phase resides predominantly in the wicking structure, and the vapor phase resides predominantly in the vapor chamber. A portable device based on the titanium thermal ground plane includes a middle frame member and a thermal ground plane with a wicking structure and a backplane formed by the middle frame member. The device includes an integrated circuit affixed to and in thermal communication with the wicking structure. A vapor cavity of the thermal ground plane is formed between the titanium backplane and sealed by welding to the wicking structure, forming the thermal ground plane.
KR 2019 0060074 A describes a mobile communication terminal including a housing, a circuit substrate with a heating element, and a bracket to support a vapor chamber. The vapor chamber includes a first metal plate, a second metal plate, and a refrigerant portion. The refrigerant portion can fill the inside of the refrigerant member and transfer heat from a high temperature portion to a low temperature portion through phase change of the refrigerant member. The vapor chamber is formed in a shape that at least partially extends in the circumferential direction of the inner surface of the terminal and at least a portion of the area of the vapor chamber is engaged with the heating element.
KR 2011 0070155 A describes a heat plate with a heat radiation area and having a pinch that can deflate the inside to form a vacuum. A refrigerant is injected inside the heat radiation area after it deflates, and a cock shielding the pinch is installed by welding the outer circumference of the pinch to the cock so as to maintain a vacuum.

### Disclosure of Invention

### Technical Problem

It is an object of the present disclosure to solve the above and other problems.

It is another object of the present disclosure to provide a display device capable of effectively cooling a heating element while occupying a relatively small volume.

It is yet another object of the present disclosure to provide a display device capable of avoiding contact or interference between a vapor chamber and elements, except for a heating element to be cooled, among elements mounted on a PCB.

### Technical Solution

According to the present invention, there is provided a display device as defined by independent claim 1. Specific embodiments are defined by the dependent claims.

### Advantageous Effects

The display device according to the present disclosure has the following effects.

According to at least one of the embodiments of the present disclosure, it is possible to provide a display device capable of effectively cooling a heating element while occupying a relatively small volume.

According to at least one of the embodiments of the present disclosure, it is possible to provide a display device capable of avoiding contact or interference between a vapor chamber and elements, except for a heating element to be cooled, among elements mounted on a PCB.

### Brief Description of Drawings

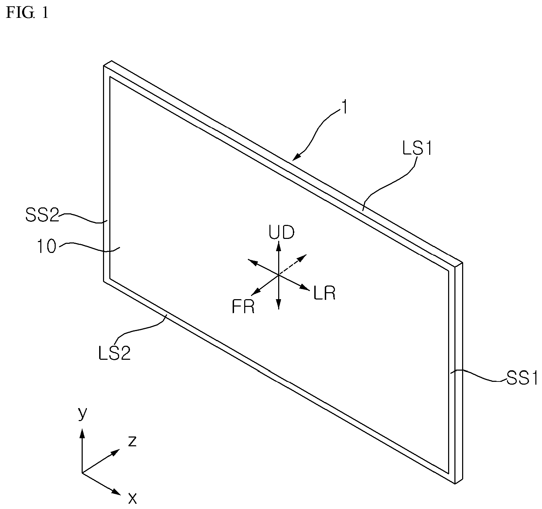

FIGS. 1 to 10 are diagrams illustrating examples of a display device according to embodiments of the present disclosure.

### Mode for Carrying Out the Invention

Hereinafter, the present disclosure will be described in detail with reference to the accompanying drawings, in which the same reference numerals are used throughout the drawings to designate the same or similar components, and a redundant description thereof will be omitted.

The terms "module" and "unit" for elements used in the following description are given simply in view of the ease of the description, and do not have a distinguishing meaning or role.

It will be understood that, although the terms first, second, etc., may be used herein to describe various elements, these elements should not be limited by these terms. These terms are only used to distinguish one element from another.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, the singular forms are intended to include the plural forms as well, unless the context clearly indicates otherwise.

In the following description, even if an embodiment is described with reference to a specific figure, if necessary, reference numeral not shown in the specific figure may be referred to, and reference numeral not shown in the specific figure is used when the reference numeral is shown in the other figures.

Referring to FIG. 1, a display device 1 may include a display panel 10. The display panel 10 may display images.

The display device 1 may include a first long side LS1, a second long side LS2 opposite to the first long side LS1, a first short side SS1 adjacent to the first long side LS1 and the second long side LS2, and a second short side SS2 opposite to the first short side SS1. Meanwhile, for convenience of explanation, it is illustrated and described that the first and second long sides LS1 and LS2 are longer than the first and second short sides SS1 and SS2, but there may also be a case in which lengths of the first and second long sides LS1 and LS2 may be approximately equal to lengths of the first and second short sides SS1 and SS2.

A direction parallel to the first and second long sides LS1 and LS2 of the display device 1 may be referred to as a first direction DR1 or a left-right direction LR. A direction parallel to the first and second short sides SS1 and SS2 of the display device 1 may be referred to as a second direction DR2 or an up-down direction UD. A direction perpendicular to the long sides LS1 and LS2 and the short sides SS1 and SS2 of the display device 1 may be referred to as a third direction DR3 or a front-rear direction FR. Here, a side on which the display panel 10 displays an image may be referred to as a front side, and a side opposite thereto may be referred to as a rear side.

In the following description of the display panel 10, a display panel using an Organic Light Emitting Diode (OLED) will be described as an example, but the display panel 10 which may be applied to the present disclosure is not limited thereto.

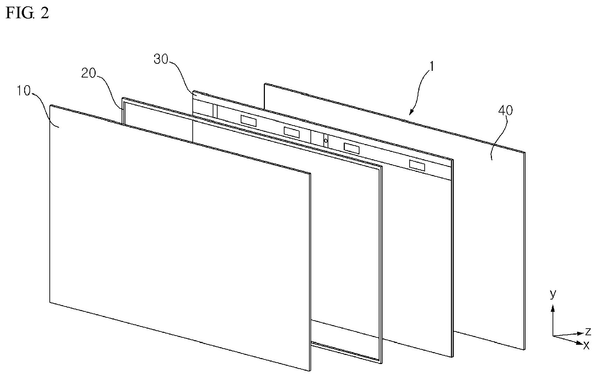

Referring to FIGS. 1 and 2, the display device 1 may include the display panel 10, a frame 20, a module cover 30, and a back cover 40.

The display panel 10 may form a front surface of the display device 1 and may display an image on the front side. The display panel 10 may divide the image into a plurality of pixels and may output the image while controlling color, brightness, and chroma of the respective pixels. The display panel 10 may be divided into an active area, in which the image is displayed, and a de-active area in which the image is not displayed. The display panel 10 may generate light corresponding to red, green, or blue color in response to a control signal.

The frame 20 may form side surfaces of the display device 1. The frame 20 may be disposed at the rear of the display panel 10 and may be coupled to the display panel 10. The frame 20 may have a generally square ring shape. For example, the frame 20 may include a metal material. For example, the frame 20 may include an aluminum (Al) material.

The module cover 30 may be disposed at the rear of the display panel 10. The module cover 30 may be coupled to the frame 20. In this case, the module cover 30 may be disposed opposite to the display panel 10 with the frame 20 being disposed therebetween.

The back cover 40 may form a rear surface of the display device 1. The back cover 40 may be coupled to the module cover 30 to cover a rear side of the module cover 30. Meanwhile, it is also possible that the back cover 40 is omitted from the display device 1, and the aforementioned module cover 30 serves as an exterior material

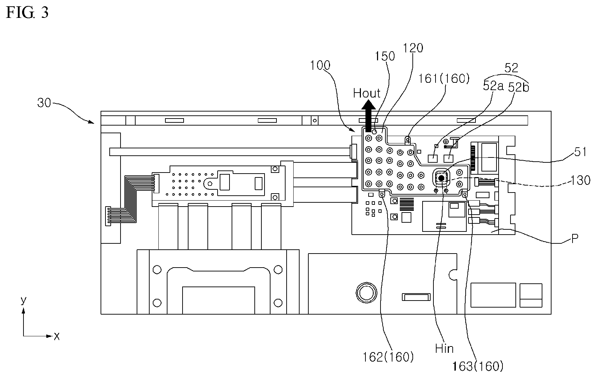

Referring to FIG. 3, various electronic components, which are electrically connected to the display panel 10, may be installed in the module cover 30. A Printed Circuit Board (PCB) P, on which a plurality of elements are mounted, may be coupled to the module cover 30. For example, the PCB P may be a main board. In this case, it is required to prevent the plurality of elements mounted on the PCB P from being exposed to high-temperature heat to prevent thermal damage, and to this end, the display device 1 may include a vapor chamber 100.

The vapor chamber 100 is coupled to the PCB P and comes into contact with a contact element 51 which is at least any one of the plurality of elements mounted on the PCB P. Here, the contact element 51 may be a heating element that generates heat when a current flows. For example, the contact element 51 may be an IC chip. In this case, the vapor chamber 100 may cool the contact element 51 by radiating heat, transferred from the contact element 51, to the outside. Accordingly, the vapor chamber 100 may prevent overheating of the contact element 51, thereby preventing thermal damage to the contact element 51 and elements adjacent thereto.

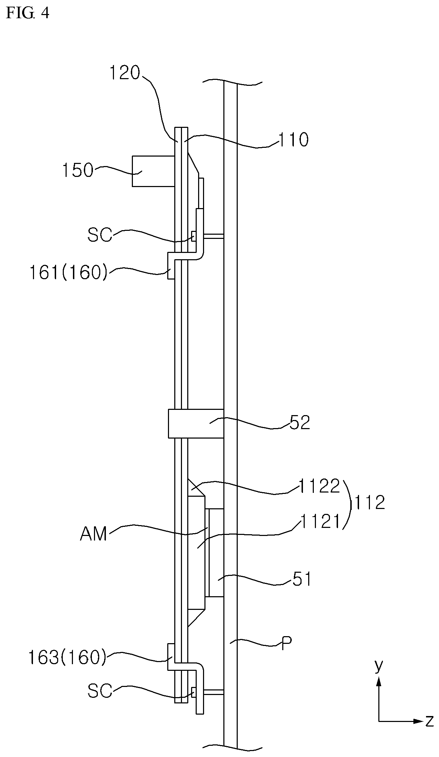

Referring to FIGS. 3 and 4, the vapor chamber 100 includes a first plate 110, a second plate 120, and a fluid FL (not shown). Heat Hin transferred from the contact element 51 to the vapor chamber 100 may evaporate the fluid FL received in the vapor chamber 100. Further, the fluid FL, which has increased in temperature, may move upward and may be condensed by radiating heat Hout to the outside at an upper end of the vapor chamber 100. In addition, the condensed fluid FL may move downward and may be evaporated and condensed repeatedly, to cool the contact element 51.

In this case, considering the characteristics that a relatively high-temperature fluid FL moves further upward than a relatively low-temperature fluid FL, it is desirable that a portion of the vapor chamber 100 that radiates heat be disposed above a portion that absorbs heat. For example, an upper end of the vapor chamber 100 may be disposed adjacent to an upper end of the module cover 30. Here, the upper end of the module cover 30 may be understood as a portion adjacent to an upper end of the display device 1 and a portion adjacent to an outside thereof. Accordingly, heat may be smoothly dissipated from the fluid FL through the upper end of the vapor chamber 100.

The first plate 110 may form a rear surface of the vapor chamber 100. The first plate 110 may include a heat absorbing part 112 that comes into contact with the contact element 51 to absorb heat generated in the contact element 51. That is, heat generated in the contact element 51 may be transferred to the fluid FL through the heat absorbing part 112 to evaporate the fluid FL.

The second plate 120 may form a front surface of the vapor chamber 100. The second plate 120 may be coupled to the first plate 110. For example, the second plate 120 may be coupled to the first plate 110 by a method, such as welding and the like. For example, the first plate 110 and the second plate 120 may include a metal material. For example, the first plate 110 and the second plate 120 may include stainless steel which is excellent in corrosion resistance.

The fluid FL may flow in a space S between the first plate 110 and the second plate 120. That is, by the above process of evaporation and condensation of the fluid FL, the fluid FL may move upward and downward in the space S. To this end, a portion of an inner surface of the first plate 110 and a portion of an inner surface of the second plate 120 may be spaced apart from each other to form the space S. For example, the fluid FL may be water.

Meanwhile, the vapor chamber 100 may further include an adhesive AM. The adhesive AM may be disposed between the heat absorbing part 112 and the contact element 51, and may be coupled to each of the heat absorbing part 112 and the contact element 51. The adhesive AM has excellent thermal conductivity, such that heat generated in the contact element 51 may be easily transferred to the heat absorbing part 112. For example, the adhesive AM may be a double-sided tape.

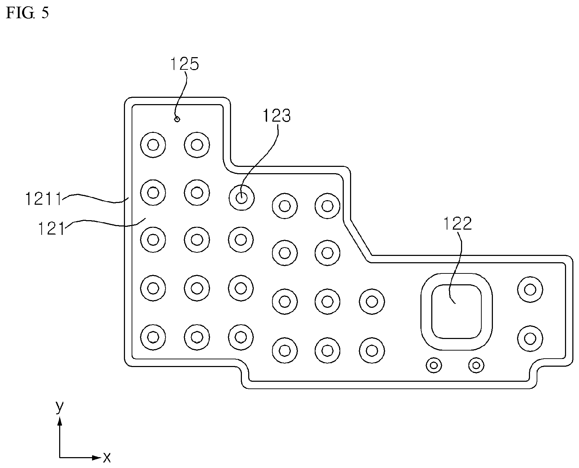

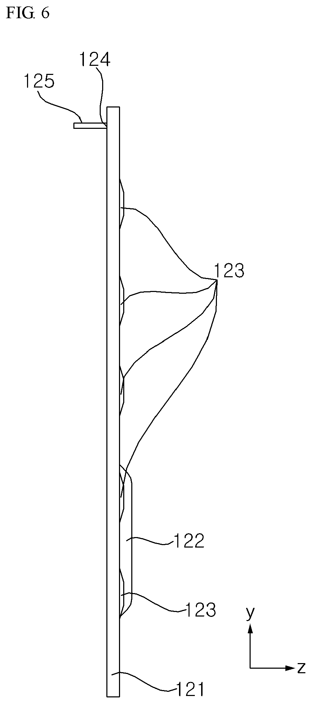

Referring to FIGS. 5 and 6, the second plate 120 may include a second body 121 having an inlet hole 124 formed therein for providing the fluid FL to the space S. For example, after the fluid FL is provided to the space S through the inlet hole 124, the space S may be made into a vacuum state by a vacuum device (not shown). For example, a pipe 125, through which the fluid FL flows, may be inserted into the inlet hole 124. For example, the pipe 125 may be a copper pipe.

A plurality of recesses 123 may be recessed inwardly from the second body 121. For example, the plurality of recesses 123 may have an embossing shape. The plurality of recesses 123 may prevent the second plate 120 and the first plate 110 from coming into close contact with each other when the space S is made into a vacuum state. Accordingly, the plurality of recesses 123 may be useful for providing the space S in a fixed size and in a vacuum state.

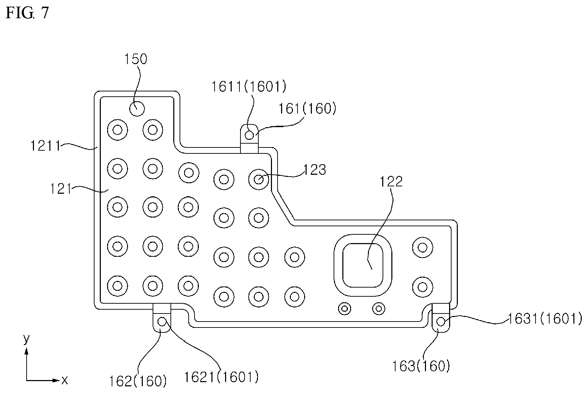

Referring to FIG. 7, a cap 150 may cover the pipe 125 coupled to the second plate 120 and inserted into the inlet hole 124. For example, the cap 150 may be formed in a cylindrical shape. For example, the cap 150 may include a rubber material.

For example, the cap 150 may be elongated in the front-rear direction (see FIG. 4). In this case, the cap 150 may prevent any components, disposed at the front of the vapor chamber 100, from coming into contact with the second plate 120.

A bracket 160 may have one side coupled to the vapor chamber 100 and the other side coupled to the PCB P. That is, the vapor chamber 100 may be coupled to the PCB P by a plurality of brackets 160. For example, the bracket 160 may include a plurality of brackets 160: 161, 162, and 163 which are spaced apart from each other.

The other side of the bracket 160 may have a hole 1601 formed therein, through which a fastening member SC fastened to the PCB P passes. Further, the other side of the bracket 160 may be spaced apart from the PCB P. In this case, by adjusting a degree of fastening of the fastening member SC fastened to the PCB P, a coupling force between the bracket 160 and the PCB P may be adjusted. For example, the fastening member SC corresponding to a screw may be screw-fastened to the PCB P through the hole 1601 (see FIG. 4). In this case, as the fastening member SC is rotated in a fastening direction of the screw, the coupling force between the bracket 160 and the PCB P may increase.

Accordingly, the heat absorbing part 112 may come into closer contact with the contact element 51, such that the heat generated in the contact element 51 may be easily transferred to the heat absorbing part 112. Alternatively, it is also possible that the vapor chamber 100 may be coupled to the PCB P by another method, such as welding and the like.

For example, the bracket 160 may include a metal material. For example, the bracket 160 may include chrome (Cr).

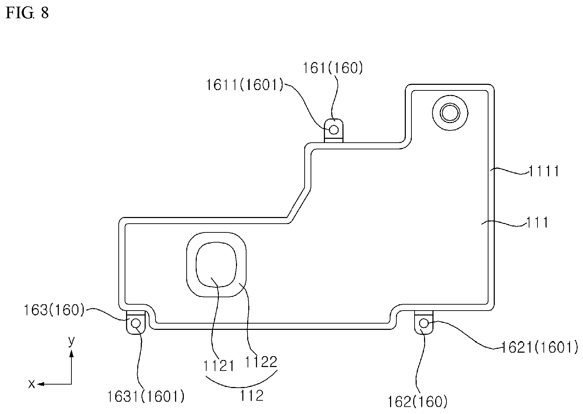

Referring to FIGS. 3 and 8, the first plate 110 may include a first body 111 having the heat absorbing part 112 formed therein. For example, the first body 111 may be a plate which is generally flat.

The first plate 110 may extend upwardly from the heat absorbing part 112 while bypassing a protruding element 52 so as not to overlap with the protruding element 52 in the front-rear direction FR, the protruding element 52 overlapping with the first plate 110 in the up-down direction UD among the plurality of elements mounted on the PCB P (see FIG. 4). Further, the second plate 120 may also bypass the protruding element 52 in the same direction as the first plate 110. For example, the first plate 110 and the second plate 120 may have generally the same shape, such that a shape of the vapor chamber 100 in relation to the protruding element 52 will be described based on the first plate 110 for brief explanation.

Accordingly, even when the protruding element 52, which protrudes further forward than the contact element 51, is disposed over the heat absorbing part 112, the first plate 110 is formed by bypassing the protruding element 52, thereby not interfering with the protruding element 52. In addition, the protruding element 52 may be prevented from coming into contact with the vapor chamber 100, thereby facilitating the above process of evaporation and condensation of the fluid FL.

The protruding element 52 may include a plurality of protruding elements 52: 52a and 52b which are spaced apart from each other. In this case, the first plate 110 may bypass each of the plurality of protruding elements 52 in the same direction. That is, after bypassing any one of the plurality of protruding elements 52 in a first direction, the first plate 110 may also bypass the rest of the protruding elements in the first direction.

Accordingly, flow resistance of the fluid FL flowing in the space S may be minimized compared to the case where the first plate 11 is formed by bypassing the respective protruding elements 52 in different directions. As a result, the contact element 51 may be cooled effectively by using the vapor chamber 100.

Referring to FIGS. 4 and 8, the heat absorbing part 112 may protrude outwardly or rearwardly from the first body 111. That is, the heat absorbing part 112 may be disposed closer to the PCB P than the first body 111, except for the heating absorbing part 112.

Accordingly, except for the contact of the contact element 51 with the heat absorbing part 112, any heating element, disposed on the PCB P, is prevented from coming into contact with the first body 111 except for the heat absorbing part, thereby facilitating the above process of evaporation and condensation of the fluid FL.

Meanwhile, a lower end of the first plate 110 may be spaced apart from the heat absorbing part 112. For example, the lower end of the first plate 110 and the heat absorbing part 112 may be spaced apart from each other according to a position of the contact element 51, a size and shape of the vapor chamber 100, a position, size, and shape of elements mounted on the PCB P, and the like.

In this case, the vapor chamber 100 may include a sheet 130 (see FIG. 3). The sheet 130 may move the fluid FL in a liquid state, which is adjacent to the lower end of the first plate 110, to the heat absorbing part 112. To this end, one end of the sheet 130 may be adjacent to the lower end of the first plate 110, and the other end of the sheet 130 may be adjacent to an upper end of the heat absorbing part 112. Accordingly, the fluid FL in a liquid state which is adjacent to the lower end of the first plate 110 may be moved by the sheet 130 to the heat absorbing part 112 to be evaporated in the heat absorbing part 112.

For example, the sheet 130 may move the fluid FL in a liquid state, which is adjacent to the lower end of the first plate 110, to the heat absorbing part 112 by capillary action. For example, the sheet 130 may include a porous material. For example, the sheet 130 may include a fiber material. For example, the sheet 130 may have a thickness of about 0.5 mm. Meanwhile, the sheet 130 may be referred to as a microfilter.

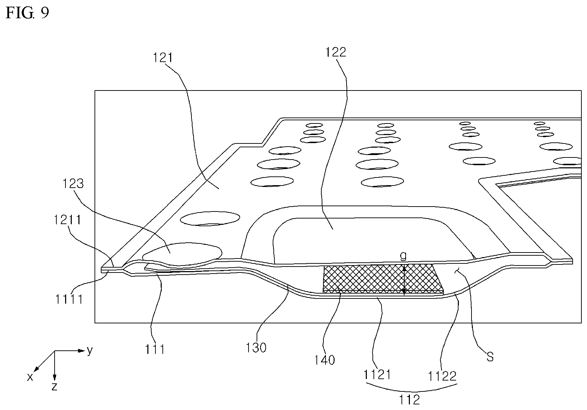

Referring to FIG. 9, a first flange 1111 formed around a circumference of the first body 111 and a second flange 1211 formed at an outer portion of the second body 121 may be coupled to each other while facing each other. For example, the first flange 1111 and the second flange 1211 may be coupled to each other by a method, such as welding and the like. In this case, an inner surface of the first body 111, except for the first flange 1111, may be spaced apart from an inner surface of the second body 121, except for the second flange 1211, to form the space S.

The heat absorbing part 112 may include a seating portion 1121 and an inclined portion 1122. A portion of the sheet 130 may be seated on the seating portion 1121. The contact element 51 may come into contact with the seating portion 1121. For example, the seating portion 1121 may be generally flat. The inclined portion 1122 may connect the seating portion 1121 and the first body 111. The inclined portion 1122 may be inclined at an obtuse angle with respect to the seating portion 1121. In this case, the sheet 130 adjacent to the lower end of the first plate 110 may extend upward and may pass through the inclined portion 1122 to be seated on the seating portion 1121.

The sheet 130 may be spaced apart from the second plate 120 or the inner surface of the second body 121. A gap between the sheet 130 and the second plate 120 or the inner surface of the second body 121 may be largest at a portion where the sheet 130 is seated on the seating portion 1121. For example, a recess 122 disposed opposite to the seating portion 1121 with the sheet 130 disposed therebetween may be recessed inward by about 1.0 mm from the second body 121, so as to be spaced apart from the seating portion 1121 by a gap (g) of about 3.6 mm.

Accordingly, as the fluid FL absorbed into the sheet 130 and moved to the seating portion 1121 is evaporated by the heat transferred from the contact element 51, a fluid FL in a gaseous state may be generated and may smoothly flow through the space S.

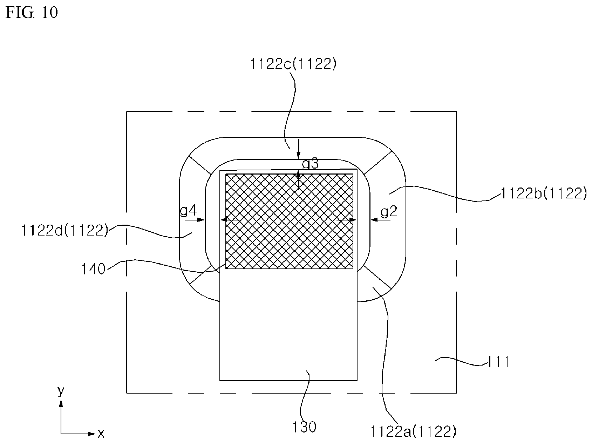

Referring to FIGS. 9 and 10, the seating portion 1121 may be generally rectangular. In this case, the inclined portion 1122 may include first to fourth inclined portions 1122a, 1122b, 1122c, and 1122d which extend from each side of the seating portion 1121. Here, the first inclined portion 1122a may be disposed between one end and the other end of the sheet 130. That is, the sheet 130 having one end adjacent to the lower end of the first plate 110 may extend upward and may pass through the first inclined portion 1122a to be seated on the seating portion 1121.

The sheet 130 may be spaced apart from the second to fourth inclined portions 1122b, 1122c, and 1122d of the inclined portion 1122, except for the first inclined portion 1122a disposed between the one end and the other end of the sheet 130. For example, a left side of the sheet 130 may be spaced apart from the second inclined portion 1122b, disposed on the left of the seating portion 1121, by a predetermined gap g2. For example, an upper side of the sheet 130 may be spaced apart from the third inclined portion 1122c, disposed over the seating portion 1121, by a predetermined gap g3. For example, the right side of the sheet 130 may be spaced apart from the fourth inclined portion 1122d, disposed on the right of the seating portion 1121, by a predetermined gap g4.

That is, the sheet 130 is placed on the seating portion 1121 without overlapping with the second to fourth inclined portions 1122b, 1122c, and 1122d, thereby preventing the sheet 130, which increases in volume by absorbing the fluid FL, from narrowing the space S formed between the second to fourth inclined portions 1122b, 1122c, and 1122d and the second body 121.

In addition, it should be understood that in order to secure the space S between the seating portion 1121 and the second body 121 for the fluid FL to smoothly flow even when the sheet 130 increases in volume, a gap between the second body 121 and the seating portion 1121 is relatively greater than a gap between the second body 121 and the inclined portion 1122.

Accordingly, even when the sheet 130 increases in volume by absorbing the fluid FL, the fluid FL evaporated from the sheet 130 may flow smoothly through the space S. Further, it is possible to prevent boiling noise which occurs when the evaporated fluid FL remains stagnant in the heat absorbing part 112.

A mesh 40 may be disposed opposite to the seating portion 1121 with the sheet disposed therebetween 130. The mesh 140 may have a plurality of pores formed therein. The mesh 140 may be coupled to the sheet 130. The mesh 130 may reduce noise occurring when bubbles of the fluid FL jetting through the sheet 130 burst. That is, the bubbles, generated when the fluid FL is evaporated from the sheet 130, may be reduced in size by the plurality of pores of the mesh 140, such that the bubbles may burst without causing loud noise.

For example, the mesh 140 is generally rectangular. For example, the mesh 140 may include a metal material. For example, the mesh 140 may include stainless steel which is excellent in corrosion resistance.

Certain embodiments or other embodiments of the invention described above are not mutually exclusive or distinct from each other. Any or all elements of the embodiments of the invention described above may be combined or combined with each other in configuration or function.

For example, a configuration "A" described in one embodiment of the invention and the drawings and a configuration "B" described in another embodiment of the invention and the drawings may be combined with each other. Namely, although the combination between the configurations is not directly described, the combination is possible except in the case where it is described that the combination is impossible.

## Claims

1. A display device (1) comprising:
a display panel (10);
a module cover (30) disposed at a rear of the display panel (10);
a PCB (P) on which a plurality of elements are positioned, the PCB coupled to the module cover (30);
a contact element (51); and
a vapor chamber (100) that contacts the contact element which is at least any one of the plurality of elements, the vapor chamber coupled to the PCB (P),
wherein the vapor chamber (100) comprises:
a first plate (110) including a heat absorbing part (112) that contacts the contact element (51);
a second plate (120) coupled to the first plate (110); and
a fluid flowing through a space provided between the first plate (110) and the second plate (120),
**characterized in that** the first plate (110) extends vertically upward from the heat absorbing part (112) while bypassing horizontally a protruding element (52) mounted on the PCB (P) so as not to overlap with the protruding element (52) in a front-rear direction, the protruding element (52) overlapping vertically with the first plate (110) in an up-down direction among the plurality of elements,
wherein the fluid is evaporated by the heat in the heat absorbing part (112) to flow vertically upwardly, and is condensed in an upper portion of the space to flow vertically downwardly.

2. The display device (1) of claim 1, wherein the protruding element (52) comprises a plurality of protruding elements (52a, 52b) which are spaced apart from each other,
wherein the first plate (110) bypasses each of the plurality of protruding elements (52a, 52b) in a same direction.

3. The display device (1) of claim 1, wherein the first plate (110) is spaced apart from the plurality of elements at portions except for the heat absorbing part (112).

4. The display device (1) of claim 3, wherein the first plate (110) comprises a first body (111) having the heat absorbing part (112) formed therein,
wherein the heat absorbing part (112) protrudes from the first body (111) toward the PCB (P).

5. The display device (1) of claim 4, further comprising an adhesive (AM) disposed between the heat absorbing part (112) and the contact element (51), and coupled to each of the heat absorbing part (112) and the contact element (51).

6. The display device (1) of claim 4, further comprising a bracket (160) having one side coupled to the vapor chamber (100), and the other side coupled to the PCB (P).

7. The display device (1) of claim 6, wherein the other side of the bracket (160) has a hole (1601) formed therein, through which a fastening member (SC) fastened to the PCB (P) passes, and is spaced apart from the PCB (P).

8. The display device (1) of claim 1, further comprising:
a pipe (125) which is inserted into a hole (124) formed in the second plate (120), and through which the fluid provided to the space through the hole (124) flows; and
a cap (150) coupled to the second plate (120) and covering the pipe (125),
wherein the cap (150) is elongated in the front-rear direction.

9. The display device (1) of claim 1, wherein an upper end of the vapor chamber (100) is adjacent to an upper end of the module cover (30).

## Patentansprüche

1. Anzeigevorrichtung (1) mit:
ein Anzeigefeld (10);
eine Modulabdeckung (30), die auf der Rückseite des Anzeigefelds (10) angeordnet ist;
eine Leiterplatte (P), auf der eine Mehrzahl von Elementen angeordnet ist, wobei die Leiterplatte mit der Modulabdeckung (30) verbunden ist;
ein Kontaktelement (51); und
eine Dampfkammer (100), die mit dem Kontaktelement in Kontakt steht, bei dem es sich um mindestens eines aus der Mehrzahl der Elemente handelt, wobei die Dampfkammer mit der Leiterplatte (P) gekoppelt ist,
wobei die Dampfkammer (100) umfasst:
eine erste Platte (110) mit einem wärmeabsorbierenden Teil (112), der das Kontaktelement (51) berührt;
eine zweite Platte (120), die mit der ersten Platte (110) gekoppelt ist; und
ein Fluid, das durch einen zwischen der ersten Platte (110) und der zweiten Platte (120) vorgesehenen Raum fließt,
**dadurch gekennzeichnet, dass** sich die erste Platte (110) von dem wärmeabsorbierenden Teil (112) aus vertikal nach oben erstreckt, während sie ein auf der Leiterplatte (P) angebrachtes vorstehendes Element (52) horizontal umgeht, so dass sie sich mit dem vorstehenden Element (52) in einer Vorne-hinten-Richtung nicht überlappt, wobei das vorstehende Element (52) die erste Platte (110) in einer Oben-Unten-Richtung unter der Mehrzahl von Elementen vertikal überlappt,
wobei das Fluid durch die Wärme in dem wärmeabsorbierenden Teil (112) verdampft wird, um vertikal nach oben zu fließen, und in einem oberen Abschnitt des Raums kondensiert wird, um vertikal nach unten zu fließen.

2. Anzeigevorrichtung (1) nach Anspruch 1, wobei das vorstehende Element (52) eine Mehrzahl von vorstehenden Elementen (52a, 52b) umfasst, die voneinander beabstandet sind,
wobei die erste Platte (110) jedes der Mehrzahl von vorstehenden Elementen (52a, 52b) in einer gleichen Richtung umgeht.

3. Anzeigevorrichtung (1) nach Anspruch 1, wobei die erste Platte (110) in Abschnitten mit Ausnahme des wärmeabsorbierenden Teils (112) von der Mehrzahl von Elementen beabstandet ist.

4. Anzeigevorrichtung (1) nach Anspruch 3, wobei die erste Platte (110) einen ersten Körper (111) umfasst, in dem der wärmeabsorbierende Teil (112) ausgebildet ist,
wobei der wärmeabsorbierende Teil (112) von dem ersten Körper (111) in Richtung der Leiterplatte (P) vorsteht.

5. Anzeigevorrichtung (1) nach Anspruch 4, ferner umfassend: einen Klebstoff (AM), der zwischen dem wärmeabsorbierenden Teil (112) und dem Kontaktelement (51) angeordnet und sowohl mit dem wärmeabsorbierenden Teil (112) als auch mit dem Kontaktelement (51) gekoppelt ist.

6. Anzeigevorrichtung (1) nach Anspruch 4, ferner umfassend: eine Halterung (160), deren eine Seite mit der Dampfkammer (100) und deren andere Seite mit der Leiterplatte (P) verbunden ist.

7. Anzeigevorrichtung (1) nach Anspruch 6, wobei die andere Seite der Halterung (160) ein darin ausgebildetes Loch (1601) aufweist, durch das ein an der Leiterplatte (P) befestigtes Befestigungselement (SC) hindurchgeht, und von der Leiterplatte (P) beabstandet ist.

8. Anzeigevorrichtung (1) nach Anspruch 1, ferner umfassend:
eine Leitung (125), die in ein in der zweiten Platte (120) ausgebildetes Loch (124) eingesetzt ist und durch die das dem Raum durch das Loch (124) zugeführte Fluid fließt; und
eine Kappe (150), die mit der zweiten Platte (120) verbunden ist und die Leitung (125) abdeckt,
wobei die Kappe (150) in der Vorne-Hinten-Richtung länglich ist.

9. Anzeigevorrichtung (1) nach Anspruch 1, wobei ein oberes Ende der Dampfkammer (100) an ein oberes Ende der Modulabdeckung (30) angrenzt.

## Revendications

1. Dispositif d'affichage (1), comprenant:
un écran d'affichage (10);
un couvercle de module (30) disposé à l'arrière de l'écran d'affichage (10);
carte de circuit imprimé (P) sur laquelle sont disposés une pluralité d'éléments, la carte de circuit imprimé est couplée au couvercle de module (30);
un élément de contact (51); et
une chambre à vapeur (100) qui entre en contact avec l'élément de contact qui est au moins l'un parmi la pluralité d'éléments, la chambre à vapeur étant couplée à la carte de circuit imprimé (P),
dans lequel la chambre à vapeur (100) comprend:
une première plaque (110) comprenant une partie absorbant la chaleur (112) qui entre en contact avec l'élément de contact (51);
un seconde plaque (120) accouplé à la première plaque (110); et
un fluide circulant dans un espace situé entre la première plaque (110) et la seconde plaque (120),
**caractérisé en ce que** la première plaque (110) s'étend verticalement vers le haut à partir de la partie absorbant la chaleur (112) tout en contournant horizontalement un élément en saillie (52) monté sur la carte de circuit imprimé (P) de manière à ne pas chevaucher l'élément en saillie (52) dans une direction avant-arrière, l'élément en saillie (52) chevauchant verticalement la première plaque (110) dans une direction haut-bas parmi la pluralité d'éléments,
dans lequel le fluide est évaporé par la chaleur dans la partie absorbant la chaleur (112) pour s'écouler verticalement vers le haut, et est condensé dans une partie supérieure de l'espace pour s'écouler verticalement vers le bas.

2. Dispositif d'affichage (1) selon la revendication 1, dans lequel l'élément en saillie (52) comprend une pluralité d'éléments en saillie (52a, 52b) qui sont espacés les uns des autres,
dans lequel la première plaque (110) contourne chacun de la pluralité d'éléments en saillie (52a, 52b) dans la même direction.

3. Dispositif d'affichage (1) selon la revendication 1, dans lequel la première plaque (110) est séparée de la pluralité d'éléments à certains endroits, à l'exception de la partie absorbant la chaleur (112).

4. Dispositif d'affichage (1) selon la revendication 3, dans lequel la première plaque (110) comprend un premier corps (111) dans lequel est formée la partie absorbant la chaleur (112),
la partie absorbant la chaleur (112) faisant saillie du premier corps (111) en direction de la carte de circuit imprimé (P).

5. Dispositif d'affichage (1) selon la revendication 4, comprenant en outre un adhésif (AM) disposé entre la partie absorbant la chaleur (112) et l'élément de contact (51), et couplé à la partie absorbant la chaleur (112) et à l'élément de contact (51).

6. Dispositif d'affichage (1) selon la revendication 4, comprenant en outre un support (160) dont un côté est accouplé à la chambre à vapeur (100) et l'autre à la carte de circuit imprimé (P).

7. Dispositif d'affichage (1) selon la revendication 6, dans lequel l'autre côté du support (160) comporte un trou (1601) dans lequel passe un élément de fixation (SC) fixé à la carte de circuit imprimé (P) et qui est espacé de la carte de circuit imprimé (P).

8. Dispositif d'affichage (1) selon la revendication 1, comprenant en outre:
une conduite (125) qui est insérée dans un trou (124) formé dans la seconde plaque (120), et à travers lequel s'écoule le fluide fourni à l'espace à travers le trou (124); et
un bouchon (150) couplé à la seconde plaque (120) et recouvrant la conduite (125),
dans lequel le bouchon (150) est allongé dans la direction avant arrière.

9. Dispositif d'affichage (1) selon la revendication 1, dans lequel une extrémité supérieure de la chambre à vapeur (100) est adjacente à une extrémité supérieur du couvercle de module (30).
